# EUROPEAN PATENT APPLICATION

(11) **EP 1 524 687 A1**
(43) Date of publication of application: **20.04.2005**
(21) Application number: 03447261.3
(22) Date of filing: 17.10.2003
(51) Int. Cl.: H01L 21/285

(54) **Silicide formation by substantially simultaneous deposition of metal and silicon**

(71) Applicant: INTERUNIVERSITAIR MICROELEKTRONICA CENTRUM VZW, 3001 Leuven (BE); Koninklijke Philips Electronics N.V., 5621 BA Eindhoven (NL)
(72) Inventor: Pawlak, Bartlomiej Jan Philips Intellectual P&S, 5656 AA Eindhoven (NL)
(74) Representative: Bird, William Edward

(57) **Abstract**

The present invention provides a method of manufacturing a semiconductor structure (20) with a connection region (11,12) comprising a compound of metal and silicon. The method of the present invention is characterised in that the metal and the silicon used to form the compound are deposited onto a semiconductor body comprising said semiconductor structure at substantially the same time. In this way only a very low thermal budget is needed to form the compound by a final annealing step. The metal, e.g. nickel or cobalt, and the silicon may be sustantially co-deposited using various methods like CVD or sputtering.

## Description

### Technical field of the invention

The present invention relates to a method for processing a semiconductor device comprising a semiconductor structure with a control electrode and a first and second main electrode by simultaneously forming meta-stable junctions and silicides on top of the junctions.

### Background of the invention

Due to the increasing integration rate of devices comprising MOSFETs (metal oxide semiconductor field effect transistors) and manufactured by means of a MOS or C(complementary)MOS process, downscaling remains a continuous challenge as not only the size of the device and its regions have to be made smaller, but also high requirements remain valid on quality and yield. The junctions requirements in such devices are related to very high dopant activation, good control over junction depth and junction abruptness. At the same time, low resistive contacts via silicides are necessary for back-end wires.

A method for providing source and drain with a contact is known from US-6,342,421. Therein a method is described in which the source and drain of a silicon MOSFET are provided with connection regions comprising a compound between a metal and silicon. The method described in this document comprises the following steps. First, the surface of the silicon substrate on the source and drain regions are etched to a predetermined depth. Amorphous B-doped silicon films are then selectively deposited onto the exposed surfaces of the silicon substrate. In that way source and drain of the device are formed. Then, titanium films are sputtered on the source and drain layers and annealing is performed by RTA (rapid thermal annealing) at 700°C for 30 seconds, thereby forming titanium silicide films.

A disadvantage of the method described above is that the formation of the compound of the metal and silicon requires a relatively high thermal budget which limits the downscaling. Hence, the method appears to be limited to a scale which is not yet small enough.

### Summary of the invention

It is an object of the present invention to provide a method for processing a semiconductor structure with a connection region comprising a compound of a metal and silicon, and a corresponding device. The method of the present invention does not require a high thermal budget and therefore is still suitable when devices are being downscaled.

The above objective is accomplished by a method and device according to the present invention.

The present invention provides a method of manufacturing a semiconductor structure with a connection region comprising a compound of metal and silicon. The method comprises depositing the metal and silicon substantially at the same time onto said semiconductor structure, or onto a semiconductor body comprising said semiconductor structure.

The method may furthermore comprise an annealing step after deposition of metal and silicon, whereby the semiconductor body is annealed e.g. at a temperature between 400 and 750°C, for example at 700°C, to form the compound comprising metal and silicon.

In one embodiment the metal and silicon used to form the compound may be deposited in such a way that after deposition the distance between atoms of the deposited metal and the deposited atoms of silicon is at most a few monolayers of either atoms.

The metal and the silicon used to form the compound may be deposited by means of sputtering. In the sputtering process, a first target comprising silicon and a second target comprising the metal may be used. In that process, the targets are electrically isolated from each other and the bias condition of both targets is alternated between a sputtering and a non-sputtering condition.

The present invention may provide a method for manufacturing a semiconductor device comprising a semiconductor body with a control electrode and a first and second main electrode, wherein the first and second main electrode are provided with a connection region comprising a compound of a metal and silicon. The method comprises depositing a metal and silicon at substantially the same time onto the semiconductor comprising said semiconductor structure .

In one embodiment the method may be used to provide a semiconductor device with a field effect transistor, in which method a semiconductor body of silicon is provided at a surface thereof with a source region and a drain region on both sides of a channel region and with a gate region positioned above the channel region and isolated therefrom by a dielectric region, the source and drain regions being provided with a connection region comprising a compound of a metal and silicon, in which method the metal is deposited on the semiconductor body and wherein the silicon used to form the compound of the metal is also deposited onto the semiconductor body and the metal and the silicon used to form the compound are deposited substantially at the same time.

The method may furthermore comprise forming a first and second main electrode, which may for example be a source and drain, by depositing silicon before the deposition of the metal and the silicon to form the compound. This also contributes to a low thermal budget of forming for example a MOSFET. Preferably, the silicon of the first and second main electrode is deposited by low temperature chemical vapour deposition at or around for example 650°C. The silicon may preferably be doped during the deposition/CVD.

The method of the present invention may furthermore comprise removing a region of the semiconductor body which has about the same size and shape of the first and second main electrode to be formed. This may be done before the deposition of the silicon used to form the first and second main electrode and may be done by means of for example an etching process. During the etching process, a small part of the semiconductor body below the gate region and at both sides thereof may be removed by means of under-etching.

The present invention also provides a semiconductor device comprising a semiconductor structure with a connection region comprising a compound of metal and silicon, wherein the semiconductor device is obtained by a method according to the present invention. The semiconductor structure may comprise a first and a second main electrode and a control electrode, the first and second main electrode being provided with a connection region comprising a compound of a metal and silicon. The semiconductor structure may be a field effect transistor.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 to 4 and 6 are sectional views of a semiconductor device at various stages in the manufacture of the device by means of an embodiment of a method in accordance with the present invention.
Fig. 5 shows the sheet resistance (ρₛₕ) of in situ doped deposited source and drain regions as grown and after an annealing step for various experiments.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

The method of the present invention may be used for the processing of many different semiconductor devices which comprise a control electrode and a first and second main electrode. In the present invention, the processing of a semiconductor device is discussed which comprises a gate electrode as control electrode and a drain and source as first and second main electrode. However, this example is only for the ease of explanation and does not limit the invention.

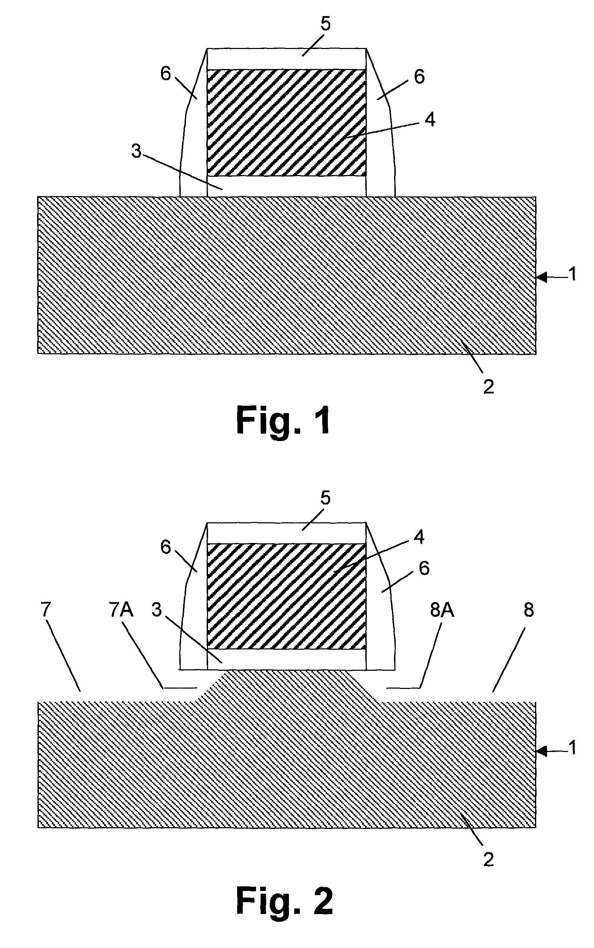

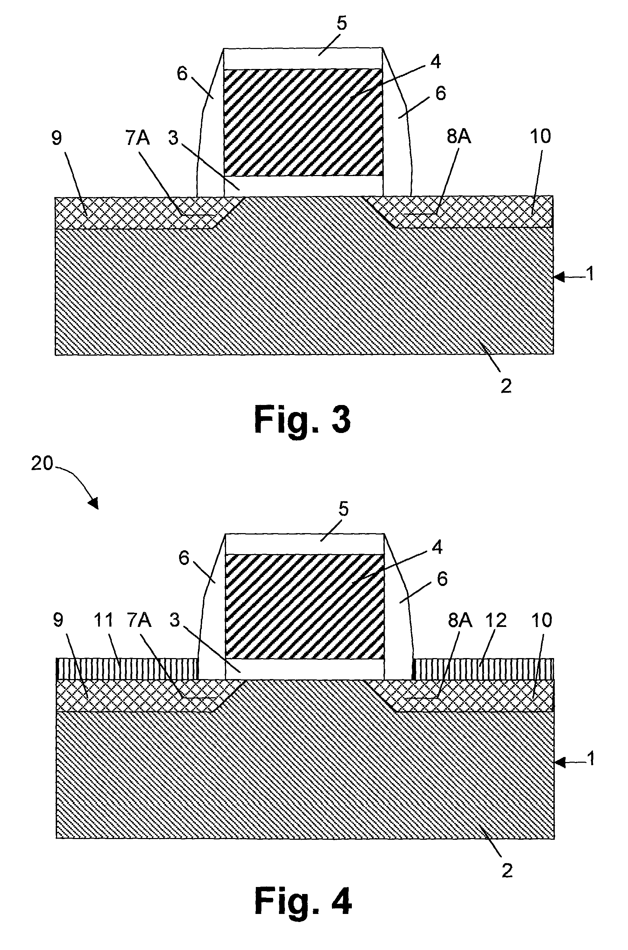

Figs. 1 through 4 are sectional views of a semiconductor device 20 at various stages in the manufacture of the device 20 by means of a method in accordance with a preferred embodiment of the present invention. Only the stages, which are most relevant for the discussion of the invention, are shown. The device 20 (see Fig. 4) comprises a semiconductor body 1 (see Fig. 1), which may for example comprise silicon, but which may alternatively be made of another suitable semiconductor material. In this embodiment of the invention, the semiconductor body 1 comprises a p-type silicon substrate 2 in which an n-type so-called well is formed, which is not shown in the drawing and which is used to form a NMOST in a CMOS process. In the drawings, only the manufacturing of a PMOST is shown. In the semiconductor body 1, among others, isolation regions, which are not shown in the drawing, may be present in the form of for example so-called trenches or LOCOS (= Local Oxidation of Silicon) regions.

Subsequently on the surface of the silicon body 1 a gate dielectric 3, which may in this embodiment for example be a gate oxide, is formed. In this embodiment the gate oxide 3 may be formed by means of thermal oxidation. However, other suitable formation or deposition techniques may also be used. Then, a semiconductor layer, in which later the gate 4 will be formed, is deposited on top of the gate dielectric 3 by means of for example CVD (= Chemical Vapour Deposition). In this embodiment, the semiconductor layer may be a polycrystalline silicon layer. On top of the semiconductor layer, a sacrificial layer/masking layer 5 is formed to protect the area where the gate 4 has to be formed. The sacrificial layer/masking layer 5 may for example be a silicon dioxide. In Fig. 6 the result after the above steps is shown.

After a photolithography process followed by etching, the gate stack is formed by patterning the gate dielectric 3 and the semiconductor layer. Hereby, the gate oxide layer 3 and the semiconductor layer are removed outside the area of the gate 4 to be formed. After patterning a conformal layer is deposited over the pattern, i.e. covering the whole of the substrate with a uniform thick layer of an insulating material, such as for example silicon oxide or silicon nitride. This conformal insulating layer is then anisotropically etched to form spacers 6 adjacent any topography on the substrate 1 and hence also lying against the gate stack 4.

Next, a part of the semiconductor body 1 of silicon is removed by for example etching. This may be done by for example exposing the semiconductor body 1 to an electro-etching process at room temperature. During the etching process, regions may be formed having about the size and shape of the source and drain region 9, 10 to be formed. In this way cavities 7, 8 may be formed at the location of the source and drain regions 9, 10 to be formed. In the etching process, the region of the semiconductor body 1 removed preferably comprises a small part below the gate region at both sides thereof obtained by under-etching. In this way, the cavities 7, 8 may be provided with shallow extensions 7A, 8A below the dielectric region 3 and the gate 4. This is illustrated in Fig. 2. This has several advantages like a good control over depth and steepness/abruptness of a junction to be formed after deposition of doped silicon.

Alternatively, if such extensions 7A, 8A are not desired, the removal of silicon may also be done by an anisotropic etching process like for example plasma etching which involves a moderate temperature increase, e.g. to between 100 and 200°C.

Subsequently, the source and drain regions 9, 10 may be formed by for example a low temperature CVD process, by which the cavities 7, 8 are filled with silicon (Fig. 3). This may for example be done at a temperature of typically 650°C and using a gaseous silicon compound as a silicon source. During deposition, the deposited silicon may be doped, which may in the preferred embodiment be done by for example providing a gaseous n-type compound like arsine (AsH₃) in the CVD reactor.

In a next step silicide is formed on top of the source and drain regions 9, 10. Herefore, the semiconductor body 1 is placed in a sputtering apparatus. The sputtering apparatus is provided with two targets, one comprising silicon and the other comprising a metal, which in this embodiment may for example be nickel. Both targets are electrically isolated from each other and are each connected to an electrical line that may either be negatively or positively biased, for example at a voltage of 1300 V DC (= Direct Current). By changing the bias to each target from positive to negative while each time the other target has the opposite bias, an alternating stream of silicon or nickel atoms can be directed towards the source and drain regions 9, 10 of the MOST. The frequency of this bias switching process may be chosen in the range of a few Hz up to the kHz range. In this way both silicon and nickel may be deposited quasi simultaneously. The quantities of each of the two materials may be regulated by choosing a different time of positive bias for each target.

Before the sputtering, the walls of the chamber and the substrate holder are heated and the chamber itself is pumped to a pressure at the level of 1 x 10⁻⁶ mbar. Then, the chamber is filled with Argon up to the pressure of 1 x 10⁻¹ mbar. The Argon functions as a sputtering medium and is ionised and ions are accelerated by the DC bias voltage and collide on the targets, where they release atoms or clusters of atoms of the target in question. These atoms or clusters drop down onto the semiconductor body 1. In this way a layer 11, 12 is deposited on top of source and drain regions 9, 10 which may have a thickness of 10 to 20 nm and may have a composition that corresponds with nickel monosilicide. Finally, the in the preferred embodiment deposited nickel and silicon, that are present in a ratio corresponding to nickel monosilicide, are annealed at a temperature of 600°C for 60 seconds.

In Fig. 4, only the nickel monosilicide layers 11, 12 deposited at the locations of the source and drain regions 9, 10 are shown. The monosilicide only being present at the source and drain regions 9, 10 may be obtained in several ways.

In a first way, after deposition of the compound stack of silicon and metal, the spacers 6 and sacrificial layer 5 may be removed by of a so-called lift off process. By doing so, the compound of metal and silicon, i.e. the metal silicide, deposited onto the spacers 6 and sacrificial layer 5 during the sputtering process, may also be removed. New spacers may be formed as described above. The sacrificial layer 5 of Fig. 4 does not need to be replaced.

Alternatively, if it is desired that also on top of the gate region 4 a silicide is formed, the sacrificial layer 5 may be removed, by for example selective etching, before the sputtering process to deposit the silicide is performed. An interruption in the deposited silicide between the gate and the source and drain regions 9, 10, which is needed to prevent a short-circuit between these regions 9, 10, may then be obtained by a slight polishing step in which the top region of the spacers 6, and hence the silicide formed on top of these top regions is removed.

The gate silicide (not shown in the drawings) however, may alternatively also be formed before forming the source and drain regions 9, 10 in a conventional manner by depositing a metal layer on top of the semiconductor layer and heating the device. As the source and drain regions 9, 10 are not present at this stage, they can not be damaged by the thermal budget involved in forming the silicide in the gate region 4.

Other ways to prevent that the sputtered silicide would be present at the side faces of the gate region 4 are formed by providing the gate 4 with a negative side slope, thus creating a shadow region where no deposition does occur. Also the use of a mask on top of the gate 4 which extends outside the gate 4 region may be used to provide the desired shadow region alongside the gate 5. This may be obtained by using a relatively wide hard mask in etching the semiconductor layer and under-etching said mask during that process.

In an alternative embodiment, in which cobalt and silicon may be co-sputtered onto source and drain regions 9, 10, an annealing step of 30 seconds at 750°C has shown to be suitable. In that case the composition corresponds with cobalt disilicide.

It is to be noted that the device 20 at this stage is not yet ready for separation from a wafer and mounting. First the usual steps of depositing one ore more dielectric layers, providing these with openings and depositing a contact metal layer, like for example an aluminium layer, which is subsequently patterned should be performed. As they are not relevant for the present invention and may be done in the usual manner, these steps are not further discussed in this description.

The method of the present invention offers the possibility to deposit substantially at the same time the metal and the silicon used to form the compound to form contacts at the source and drain regions 9, 10. In that way the diffusion path which either one of the atoms of the materials involved need to "walk" before they can react with the atoms of the other material can be very limited, which also limits the thermal budget needed to form the connection regions comprising the silicide compound 11, 12. The required small diffusion needed is then delivered by an annealing step at a relatively low temperature and/or during a relatively short time. An additional and important advantage of the method according to the invention is that it offers a more easy and precise control possibility of the composition of the silicide layers 11, 12 to be formed.

In one embodiment of the invention, the metal and silicon used to form the silicide compound 11, 12 are deposited in such a way that after deposition the distance between atoms of the deposited metal and the deposited atoms of silicon is at most a few monolayers of either atoms. This can be obtained by depositing, by means of for example an ALD (= Atomic Layer Deposition) technique, very thin, at most a few monolayers thick, alternating layers of the metal and of silicon. By choosing suitable volatile compounds of not only silicon but also of the metal, the same result may be obtained by for example CVD (= Chemical Vapour Deposition). This has the advantage that in case the silicon of source and drain regions 9, 10 are formed also by CVD, only one technique is used for forming source and drain 9, 10 and the silicide connection regions 11, 12 on top thereof. This implies that no machine-switching is needed between the deposition of source and drain 9, 10 on the one hand and deposition of the silicide compound 11, 12 on the other hand.

In a favourable embodiment the silicon of the source and drain region 9, 10 is also deposited and this deposition is done before the deposition of the metal and the silicon used to form the compound 11, 12. This also contributes to a low thermal budget of forming e.g. a MOSFET. Preferably, the silicon of the source and drain region 9, 10 is deposited by low temperature chemical vapour deposition at or around for example 650°C. The silicon is preferably doped during the deposition or CVD. A surprisingly high activation and corresponding low sheet resistance of the source and drain 9, 10 are obtained after an anneal at a relatively low temperature between 400 and 750°C, for example at 700°C. The latter anneal is preferably done after the co-deposition of the metal and the silicon used to form the compound. This anneal then also finalises the reaction between the metal and the silicon used to form the compound, in forming the metal silicide 11, 12.

Another advantage of the method of the present invention is that it only requires a single anneal to form the silicide 11, 12 onto the source and drain regions 9, 10 and to enhance at the same time the activation within the deposited source and drain 9, 10.

Furthermore, any suitable metal may be chosen to form the silicide, without taking care of its diffusion properties. The metal may be chosen on the basis of its silicide formation possibilities and its work function.

Because of the low temperature annealing step, no damage will be brought to the material of the semiconductor device.

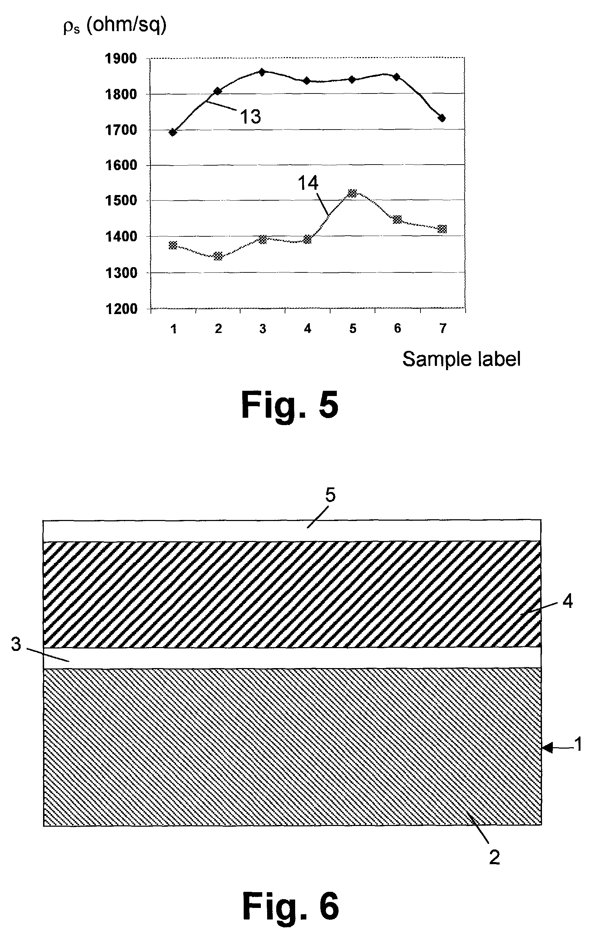

Fig. 5 shows the sheet resistance (ρₛₕ) of in situ doped deposited source and drain regions 9, 10 as grown (curve 13) and after an annealing step (curve 14) for various experiments. The experiments are numbered from 1 to 7 (= sample label). Curve 13 shows the results for the as grown devices. Curve 14 represents the results after an additional short annealing step at 700°C. Comparison of curves 13 and 14 shows that the additional anneal may enhance the activation level of the dopant atoms even by 50 % without affecting the actual dopant profile.

It is to be understood that although preferred embodiments, specific constructions and configurations, as well as materials, have been discussed herein for devices according to the present invention, various changes or modifications in form and detail may be made without departing from the scope and spirit of this invention.

For example, instead of silicon nitride for the sacrificial region 5 also other suitable materials or combination of materials may be used such as silicon oxynitride or an alloy of silicon and germanium. The spacers 6 may then be made of another material than silicon dioxide e.g. of silicon nitride. Furthermore instead of a thermal oxide, a deposited oxide could be used to form the gate dielectric 4. Also a silicon nitride or silicon-oxygen-nitride may be used for this purpose.

It is further to be noted that to form a silicide, other metals may be used than nickel such as for example cobalt, titanium or molybdenum. The silicidising may be done in one single step. Instead of a polycrystalline gate 4, doped or not or provided with a silicide or not, also a metal may be used to form the gate 4. In the latter case, silicidising the gate 4 is not necessary which may be very compatible with a method according to the present invention.

Finally, it is to be noted that the invention also may be advantageously used in cases were the source and drain regions 9, 10 are also made by deposition of silicon but where no silicon of the semiconductor body 1 is removed by etching before the deposition of the silicon for the source and drain regions 9, 10.

## Claims

1. A method of manufacturing a semiconductor structure (20) with a connection region (11, 12) comprising a compound of metal and silicon, the method comprising depositing the metal and silicon substantially at the same time onto a semiconductor body (1) comprising said semiconductor structure (20).

2. The method according to claim 1, furthermore comprising an annealing step wherein after deposition of the metal and silicon, the semiconductor body (1) is annealed.

3. The method according to claim 2, wherein the annealing step is performed at a temperature between 400 and 750°C to form the compound comprising metal and silicon.

4. The method according to any of the previous claims, wherein the metal and silicon used to form the compound are deposited in such a way that after deposition the distance between atoms of the deposited metal and between atoms of the deposited silicon is at most a few monolayers of either atoms.

5. The method according to any of the previous claims, wherein the metal and the silicon used to form the compound are deposited by means of sputtering.

6. The method according to claim 5, wherein a first target is used in the sputtering process comprising silicon and a second target comprising the metal which targets are electrically isolated from each other and wherein the bias condition of both targets is alternated between a sputtering and a non-sputtering condition.

7. The method according to any of the previous claims, wherein the semiconductor structure (20) comprises a first and a second main electrode (9, 10) and a control electrode (4), the first and second main electrode (9, 10) being provided with a connection region (11, 12).

8. The method according to claim 7, furthermore comprising forming the first and second main electrode (9, 10) by depositing silicon before the deposition of the metal and the silicon used to form the connection region (11, 12).

9. The method according to claim 8, wherein the silicon of the first and second main electrode (9, 10) are deposited by low temperature chemical vapour deposition and the silicon is doped during the deposition.

10. The method according to any of claims 8 or 9, wherein before the deposition of the silicon used to form the first and second main electrode (9, 10), a region of the semiconductor body (1) having about the size and shape of the first and second main electrode (9, 10) to be formed is removed by means of an etching process.

11. The method according to claim 10, wherein the region of the semiconductor body (1) removed comprises a small part below the control electrode (4) and at both sides thereof obtained by under-etching during the etching process.

12. The method according to any of claims 7 to 11, wherein the semiconductor structure (20) is a field effect transistor with a gate electrode (4) and a source and a drain (9, 10).

13. Semiconductor device comprising a semiconductor structure (20) with a connection region (11, 12) comprising a compound of a metal and silicon, wherein the semiconductor device is obtained by a method according to any of the previous claims.

14. The semiconductor device according to claim 13, wherein the semiconductor device comprises a semiconductor structure with a first and a second main electrode (9, 10) and a control electrode (4), the first and second main electrode (9, 10) being provided with a connection region (11, 12) comprising a compound of a metal and silicon.

15. The semiconductor device according to claim 14 wherein the semiconductor structure is a field effect transistor.
